# EUROPEAN PATENT SPECIFICATION

(11) **EP 2 632 240 B1**
(45) Date of publication and mention of the grant of the patent: **24.08.2016**
(21) Application number: 12191079.8
(22) Date of filing: 02.11.2012
(51) Int. Cl.: H05K 7/14

(54) **Connection device for cable management arm and slide assembly**
Anschlussvorrichtung für einen Kabelverwaltungsarm und Schubanordnung
Dispositif de connexion pour bras de gestion de câble et ensemble coulissant

(30) Priority: 21.02.2012 TW 101105789
(43) Date of publication of application: 28.08.2013
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Huang, Chien-Li, Kaohsiung City (TW); Wang, Chun-Chiang, Kaohsiung City (TW)
(74) Representative: Viering, Jentschura & Partner mbB Patent- und Rechtsanwälte

(56) References cited:
- CN-A- 101 346 049
- US-A1- 2004 079 711
- US-A1- 2004 120 134
- US-A1- 2006 113 433
- US-A1- 2009 065 658
- US-A1- 2011 100 933
- US-B2- 7 473 846

## Description

### FIELD OF THE INVENTION

The present invention relates to a connection device, and more particularly, to a connection device for a cable management arm and a slide assembly, and the connection device occupies less space and can be operated from two sides thereof.

### BACKGROUND OF THE INVENTION

U.S. Patent No. 7,473,846 to Doerr discloses a reversible cable support arm and Figure 7 of the disclosure discloses a cable support arm 24 connected to the rails 108 and a mounting bracket 92 is connected to an end of the cable support arm. The lower portion 100 of the mounting bracket has multiple keyholes slots 94 and a plunger 98. The connection between the rails and the cable support arm is made by inserting the plungers 98, 132 to holes of the corresponding objects.

U.S. Patent No. 2004/0079711 A1 to Hartman discloses a cable management assembly including a first arm assembly pivotally connected with a second arm assembly. Each arm assembly includes a slide lock which may tool-lessly couple to a slide lock receptacle attached to a rack slide chassis member or a rack slide stationary member, allowing the cable management assembly to be chassis independent and reversible. The arm assemblies include basket trays with movable covers that facilitate the storage of cabling. However, the release of the arm assemblies is quite complicated.

However, the plungers 98, 132 protrude beyond the chassis and which restrict the width and space when the chassis is installed in the rack. When the cable support arm is removed from the rails, the plungers provide only one removal direction. This restriction of direction, especially when the chassis is to be removed from the rack from the storage position, the restriction of the available space makes it more difficult for pulling the plungers to release the connection between the cable support arm and the rails.

The present invention intends to provide a connection device between the cable management arm and the slide assembly, wherein the connection between the cable management arm and the slide assembly can be released from two sides.

### SUMMARY OF THE INVENTION

According to the aspect of the present invention, the present invention relates to a connection device for a cable management arm and a slide assembly. The connection device comprises a connection member fixedly connected to the cable management arm. The connection member comprises a pair of bent portions and a sidewall which is connected between the bent portions. A passage is defined by the bent portions and the sidewall. The sidewall has a window. An engaging member is fixed to the sidewall of the connection member and has a resilient arm and an engaging portion, wherein the resilient arm extends to the window of the connection member. An insertion piece is fixed to the slide assembly and has two insertion arms and a body which is connected between the two insertion arms. The thickness of each of the insertion arms is sized to match with the width of the passage so that the insertion arms are inserted into the passage. One of the insertion arms has a contact section located corresponding to the engaging portion. When the insertion arms of the insertion piece are completely inserted into the passage, the engaging portion of the engaging member is located between the body of the insertion piece and the contact section of the insertion arm to maintain the insertion piece to be positioned on the connection member.

Preferably, the window is a T-shaped opening and has an enlarged hole and a narrow hole which communicates with the enlarged hole. The sidewall has at least one stop which is in contact with the insertion piece to restrict the depth that the insertion piece is inserted into the connection member.

Preferably, the engaging portion extends from the insertion piece and reaches the enlarged hole of the window.

Preferably, the engaging portion has a protruding contact piece which is located corresponding to the contact section. The contact section has a contact end with which the contact piece is in contact so as to position the insertion piece by the engaging member.

Preferably, the engaging portion has a bent section located in opposite to the contact piece. The bent section is located corresponding to the insertion arm which has an inclined guiding surface with which the bent section is slidably in contact.

Preferably, a button with two faces is connected to the resilient arm of the engaging member.

According to another aspect of the present invention, the present invention provides a cable management system which comprises a cable management arm, a slide assembly and a connection device. The cable management arm comprises a first arm and a second arm which is pivotably connected to the first arm. The slide assembly has a first rail and a second rail which is slidable relative to the first rail. The connection device has a connection member fixedly connected to one of the first and second arms. The connection member has a pair of bent portions and a sidewall which is connected between the bent portions. A passage is defined by the bent portions and the sidewall. The sidewall has a window. An engaging member is fixed to the sidewall of the connection member and has a resilient arm and at least one engaging portion, wherein the resilient arm extends to the window of the connection member. The at least one engaging portion extends from the resilient arm and reaches the window. The at least one engaging portion has a bent section. An insertion piece is fixed to one of the first rail and the second rail of the slide assembly. The insertion piece has two insertion arms and a body which is connected between the two insertion arms. The insertion arms are inserted into the passage. One of the insertion arms has a contact section located corresponding to the at least one engaging portion. When the insertion arms of the insertion piece are inserted into the passage, the insertion arms contact the bent section and lift the at least one engaging portion. The contact section is moved relative to the at least one engaging portion to keep the engaging portion being supported by the contact section. The insertion piece is completely inserted into the passage and the contact section of the insertion piece does not contact the at least one engaging portion of the engaging member. The at least one engaging portion returns to an original position and contacts the contact section to stop the insertion arms from disengaging from the passage. The insertion piece is maintained to be positioned on the connection member.

Preferably, the insertion arm has an inclined guiding surface which is located corresponding to the bent section of the at least one engaging portion.

Preferably, the sidewall has at least one stop which is in contact with the insertion piece to restrict the depth that the insertion piece is inserted into the connection member.

According to a further aspect of the present invention, the present invention further provides a connection device for a cable management arm and a slide assembly. The connection device comprises a connection member which has a pair of bent portions and a sidewall which is connected between the bent portions. A passage is defined by the bent portions and the sidewall. The sidewall has a window and at least one stop. The window has an enlarged hole and a narrow hole which communicates with the enlarged hole and is located on one side of the enlarged hole. An engaging member is fixed to the sidewall of the connection member and has a resilient arm and at least one engaging portion. The resilient arm extends from the narrow hole of the window and reaches the enlarged hole. The at least one engaging portion has a bent section. An insertion piece has two insertion arms and a body which is connected between the two insertion arms. The thickness of each of the insertion arms is sized to match with the width of the passage so that the insertion arms are inserted into the passage. One of the insertion arms has a contact section located corresponding to the at least one engaging portion. The contact section has a contact end which is located corresponding to the at least one engaging portion. The insertion arm has an inclined guiding surface which is located corresponding to the bent section of the at least one engaging portion. When the insertion arms are inserted into the passage, the at least one engaging portion is lifted by the contact section and the insertion piece is completely inserted into the passage. The insertion arms contact the stop. The contact section is separated from the at least one of the engaging portion of the engaging member. The at least one of the engaging portion of the engaging member returns to its initial position thereof. The contact end of the contact section contacts the at least one engaging portion of the engaging member.

The present invention will become more obvious from the following description when taken in connection with the accompanying drawings which show, for purposes of illustration only, a preferred embodiment in accordance with the present invention.

### BRIEF DESCRIPTION OF THE DRAWINGS

Fig. 1 shows that the connection device of the present invention is cooperated with the cable management arm and the slide assembly;
Fig. 2 is an exploded view to show the connection device of the present invention;
Fig. 3 shows that the connection device of the present invention;
Fig. 4 shows the action that the insertion piece is inserted into the connection member;
Fig. 5 shows another action that the insertion piece is inserted into the connection member;
Fig. 6 shows the action that the insertion piece is engaged with the engaging member;
Fig. 7 shows another action that the insertion piece is engaged with the engaging member;
Fig. 8 shows that the insertion piece is disengaged from the engaging member, the engaging member in the status disclosed in Fig. 6 is released by being pushed in the first direction, and
Fig. 9 shows that the insertion piece is disengaged from the engaging member and the engaging member in the status disclosed in Fig. 6 is released by being pushed in the second direction.

### DETAILED DESCRIPTION OF THE PREFERRED EMBODIMENT

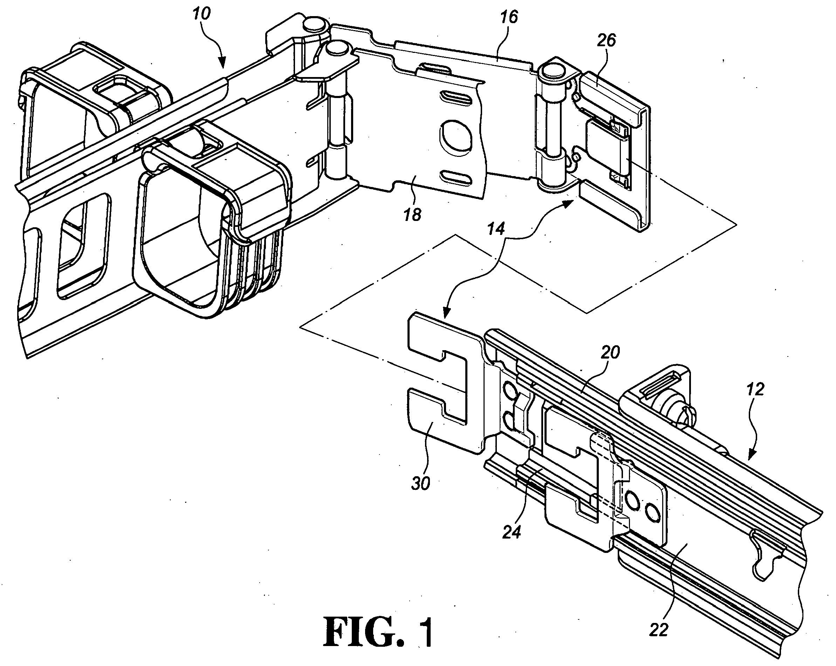

Referring to Fig. 1, the preferable embodiment of the connection device 14 of the present invention is cooperated with a cable management arm 10 and a slide assembly 12. The cable management arm 10 comprises a first arm 16 and a second arm 18 which is pivotably connected to the first arm 16. The slide assembly 12 has a first rail 20 and a second rail 22 which is slidable relative to the first rail 20. Preferably, a third rail 24 is slidably connected between the first and second rails 20, 22, so that the second rail 22 can be extended a further distance relative to the first rail 20 by the third rail 24.

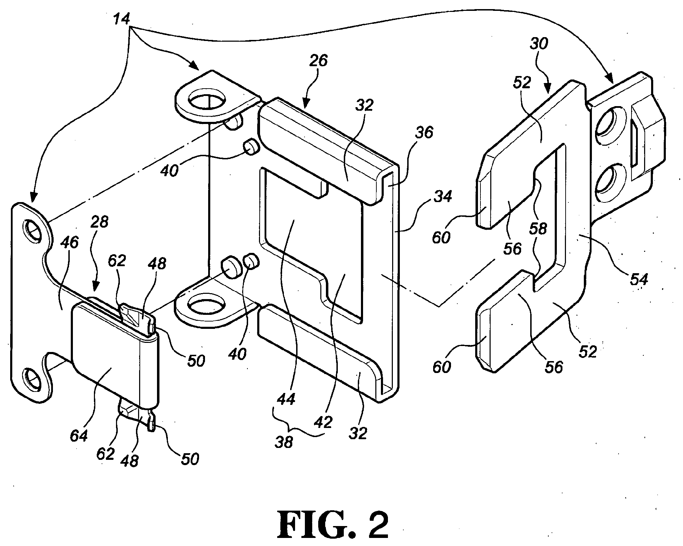

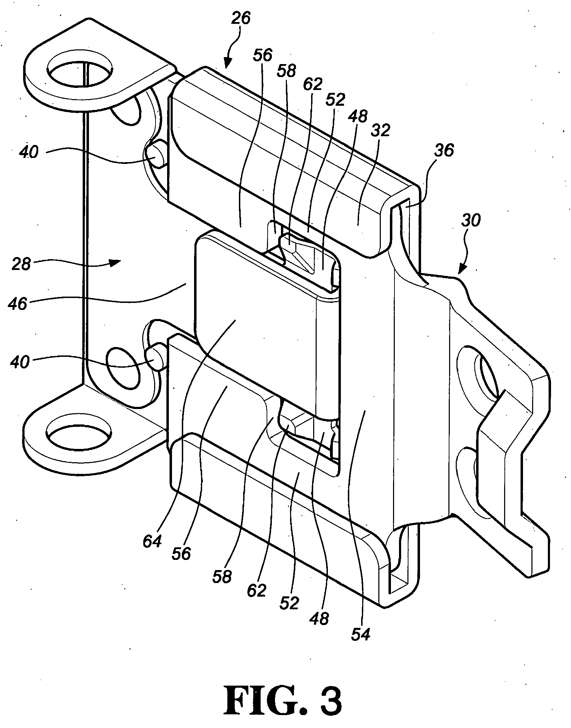

Figs. 2 and 3 show that the connection device 14 comprises a connection member 26, an engaging member 28 and an insertion piece 30.

The connection member 26 is fixedly connected to the cable management arm 10. As shown in Fig. 1, preferably, the connection member 26 is fixedly connected to one of the first and second arms 16, 18 of the cable management arm 10. The connection member 26 has a pair of bent portions 32 and a sidewall 34 connected between the bent portions 32. A passage 36 is defined by the bent portions 32 and the sidewall 34. The sidewall 34 has a window 38 and one or two stops 40. Preferably, the window 38 is a T-shaped opening and has an enlarged hole 42 and a narrow hole 44 which communicates with one side of the enlarged hole 42.

The engaging member 28 is fixed to the sidewall 34 of the connection member 26 and has a resilient arm 46 and an engaging portion 48 or two engaging portions 48. The resilient arm 46 extends to the window 38 of the connection member 26. In detail, the resilient arm 46 extends through the narrow hole 44 of the window 38 and reaches the enlarged hole 42. The engaging portion 48 extends from the resilient arm 46 and reaches the enlarged hole 42 of the window 38. In a preferable embodiment, the engaging portion 48 has a bent section 50.

The insertion piece 30 is fixed to the slide assembly 12. Further referring to Fig. 1, the insertion piece 30 is fixed to one of the first rail 20 and the second rail 22 of the slide assembly 12. The insertion piece 30 has two insertion arms 52 and a body 54 which is connected between the two insertion arms 52. The thickness of each of the insertion arms 52 is sized to match with the width of the passage 36 and the insertion arms 52 is inserted into the passage 36. One of the insertion arms 52 has a contact section 56 located corresponding to the engaging portion 48. In a preferable embodiment, the contact section 56 has a contact end 58. One of the insertion arms 52 or the two insertion arms 52 have an inclined guiding surface 60 which is located corresponding to the bent section 50 of the engaging portion 48. In a preferable embodiment, the engaging portion 48 has a protruding contact piece 62 which is located corresponding to the contact end 58. The bent section 50 is located in opposite to the contact piece 62 and located corresponding to one of the insertion arms 52 or the inclined guiding surface 60. A plastic button 64 with two faces is connected to the resilient arm 46 of the engaging member 28 so that the button 64 can be operated from both sides.

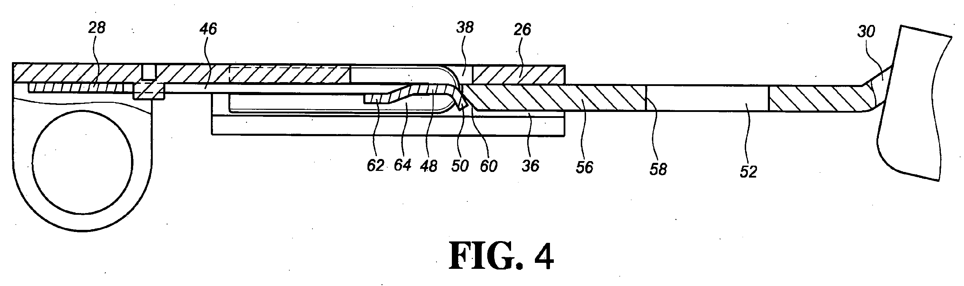

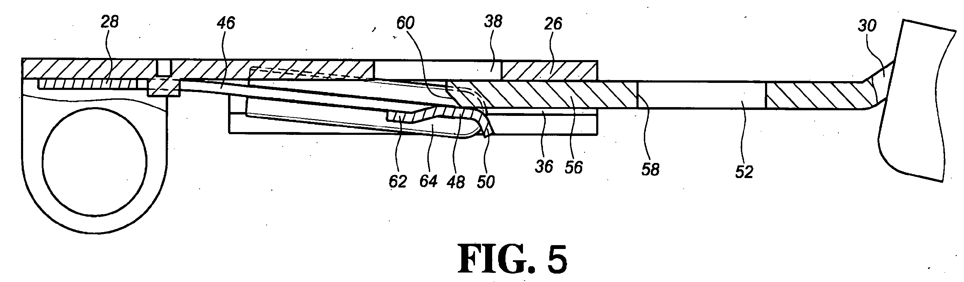

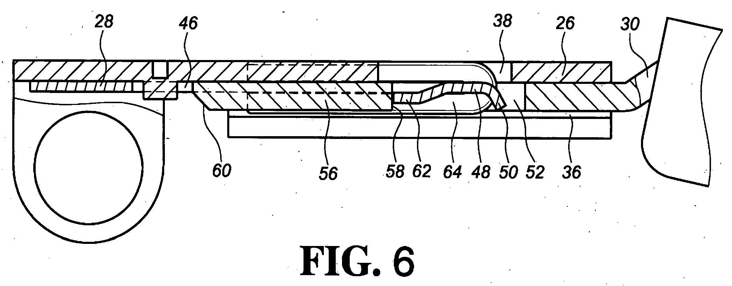

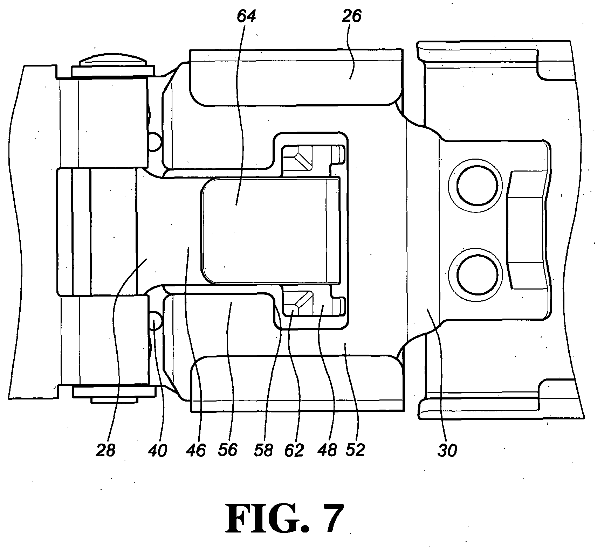

As shown in Figs. 4 and 5, when the insertion arms 52 of the insertion piece 30 are inserted into the passage 36, the bent section 50 of the insertion arm 52 is guided by the inclined guiding surface 60 and pushed by the contact section 56 so that the engaging portion 48 of the engaging member 28 is in contact with the contact section 56 of the insertion arm 52 by the resilient force from the resilient arm 46. Along with the insertion of the insertion piece 30 inserted into the passage 36 and moved toward the engaging member 28, the engaging portion 48 is kept lifted by the contact section 56 until the contact section 56 of the insertion arm 52 is completely inserted into the passage 36 of the connection member 26. As shown in Figs. 6 and 7, the engaging portion 48 is disengaged from the contact section 56 which is no longer contact with the engaging portion 48 of the engaging member 28. The resilient force from the resilient arm 46 of the engaging member 28 is released to return the engaging portion 48 to its initial position where the engaging portion 48 contacts the contact end 58 or the engaging portion 48 is located corresponding to the contact end 58. That is to say, when the connection member 26 and the engaging member 28 are pulled and separated from each other in two opposite directions, the contact piece 62 of the engaging portion 48 of the engaging member 28 stops the contact end 58 of the contact section 56 of the insertion arm 52. In this status, the engaging portion 48 of the engaging member 28 is restricted between the body 54 of the insertion piece 30 and the contact section 56 of the insertion arm 52. Therefore, the insertion arm 52 of the insertion piece 30 cannot be removed from the passage 36 of the connection member 26. The insertion piece 30 is maintained to be positioned on the connection member 26.

It is noted that the user can push the button 64 of the resilient arm 46 of the engaging member 28 to assist the insertion of the insertion arm 52 of the insertion piece 30 to the passage 36 of the connection member 26 without the help from the bent section 50 of the engaging portion 48 or the inclined guiding surface 60 of the contact section 56, the insertion piece 30 can be completely inserted into the connection member 26.

In a preferable embodiment, the insertion piece 30 can contact the stop 40 of the connection member 26 to restrict the depth of the insertion of the insertion piece 30 in the connection member 26. The engaging portion 48 of the engaging member 28 stops at the pre-set position relative to the insertion piece 30.

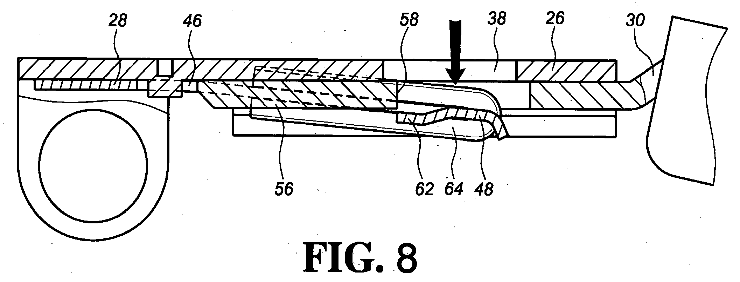

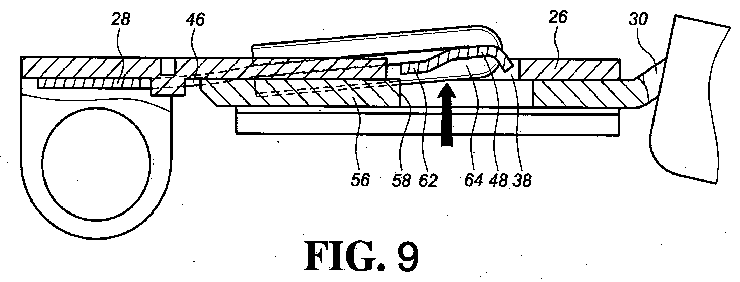

As shown in Figs. 8 and 9, when removing the insertion piece 30 from the connection member 26, the user may push the button 64 of the engaging member 28 via either direction of the window 38 of the connection member 26 to operate the resilient arm 46 so that the contact piece 62 of the engaging portion 48 of the engaging member 28 does not stop the contact end 58 of the contact section 56. The insertion piece 30 can be removed from the connection member 26.

The connection device provides convenient connection between the slide assembly 12 and the cable management arm 10, especially, the user may push the button 64 of the engaging member 28 via either direction of the window 38 of the connection member 26 to release the connection between the slide assembly 12 and the cable management arm 10. The connection device uses the window to accommodate parts to reduce the parts that protrude so as to be slim and thin, and occupy less space.

While we have shown and described the embodiment in accordance with the present invention, it should be clear to those skilled in the art that further embodiments may be made without departing from the scope of the present invention.

## Claims

1. A connection device (14) for a cable management arm (10) and a slide assembly (12), comprising:
a connection member (26) having a pair of bent portions (32) and a sidewall (34) connected between the bent portions (32), a passage (36) defined by the bent portions (32) and the sidewall (34), the sidewall (34) having a window (38);
an engaging member (28) fixed to the sidewall (34) of the connection member (26) and having a resilient arm (46) and an engaging portion (48), the resilient arm (46) extending to the window (38) of the connection member (26), and
an insertion piece (30) having two insertion arms (52) and a body (54) connected between the two insertion arms (52), a thickness of each of the insertion arms (52) being sized to match with a width of the passage (36) and the insertion arms (52) inserted into the passage (36), one of the insertion arms (52) having a contact section (56) located corresponding to the engaging portion (48);
wherein, when the insertion arms (52) of the insertion piece (30) are completely inserted into the passage (36), the engaging portion (48) of the engaging member (28) is located between the body (54) of the insertion piece (30) and the contact section (56) of the insertion arm (52) to maintain the insertion piece (30) to be positioned on the connection member (26), **characterized in that**
the connection member is fixedly connected to the cable management arm (10), and
the insertion piece (30) is fixed to the slide assembly (12),
and wherein the engaging member (28) is fixed to the sidewall (34) of the connection member (26) on the same side of the sidewall (34) as the side where the passage (36) is defined and may be pushed via either direction of the window (38),
and
the connection device (14) uses the window (38) to accommodate parts of the engaging member (28) that protrude so as to be slim and occupy less space.

2. The connection device (14) as claimed in claim 1, wherein the window (38) is a T-shaped opening and has an enlarged hole (42) and a narrow hole (44) which communicates with a side of the enlarged hole (42), the sidewall (34) has at least one stop (40) which is in contact with the insertion piece (30) to restrict the depth that the insertion piece (30) is inserted into the connection member (26).

3. The connection device (14) as claimed in claim 2, wherein the engaging portion (48) extends from the resilient arm (46) and reaches the enlarged hole (42) of the window (38).

4. The connection device (14) as claimed in claim 3, wherein the engaging portion (48) has a protruding contact piece (62) which is located corresponding to the contact section (56), the contact section (56) has a contact end (58) with which the contact piece (62) is in contact so as to position the insertion piece (30) by the engaging member (28).

5. The connection device (14) as claimed in claim 4, wherein the engaging portion (48) has a bent section (50) located in opposite to the contact piece (62), the bent section (50) is located corresponding to the insertion arm (52) which has an inclined guiding surface (60) with which the bent section (50) is slidably in contact.

6. The connection device (14) as claimed in claim 1, wherein a button (64) with two faces is connected to the resilient arm (46) of the engaging member (28).

## Patentansprüche

1. Eine Übergangsvorrichtung (14) für einen Kabelführungsarm (10) und einen Schlitten (12), umfassend:
ein Verbindungsglied (26) mit einem Paar gebogener Flansche (32), wobei zwischen diesen gebogenen Flanschen (32) eine Seitenwand (34) gebildet ist; mit den gebogenen Flanschen (32) und der Seitenwand (34) ein Durchgang (36) gebildet ist, wobei die Seitenwand (34) eine Öffnung (38) aufweist;
ein Einschnappglied (28), das an der Seitenwand (34) des Verbindungsgliedes (26) befestigt ist, wobei an diesem Einschappglied (28) ein federnder Arm (46) und ein Einrastteil (48) befestigt sind; der federne Arm (46) sich zur Öffnung (38) des Verbindungsgelides (26) erstreckt, und
einen Einrastteil (30)
mit zwei Einrastarmen (52), wobei zwischen diesen beiden Einrastarmen (52) ein Körper (54) befestigt ist; eine Dicke eines jeden der Einrastarme (52) die Größe aufweist, die einer Breite des Durchgangs (36) entspricht, wobei die Einrastarme (52) in diesen Durchgang (36) eingeschoben sind; einer der Einrastarme (52) einen Kontaktteil (56) an einer Stelle in Übereinstimmung mit dem Einrastteil (48) aufweist;
wobei beim vollständigen Einschieben der Einrastarme (52) des Einrastteils (30) in den Durchgang (36) der Einrastteil (48) des Einschnappgliedes (28) zwischen dem Körper (54) des Einrastteils (30) und dem Kontaktteil (56) des Einrastarms (52) angeordnet ist, um den Einrastteil (30) am Verbindungsglied (26) positioniert zu halten, dadurchgekennzeichnet, dass
das Verbindungsglied (26) sicher am Kabelführungsarm (10) befestigt ist,
und
der Einrastteil (30) am Schlitten (12) befestigt ist,
und wobei das Einschnappglied (28) an der Seitenwand (34) des Verbindungsgliedes (26) auf derselben Seite der Seitenwand (34), auf der der Durchgang (36) gebildet ist, befestigt ist und in beide Richtungen des Fensters (38) verschoben werden kann, und
im Fenster (38) der Übergangsvorrichtung (14) die Einzelteile des Einschnappgliedes (28) aufgenommen sind, die vorstehen, um diese schlank und platzsparend auszuführen.

2. Die Übergangsvorrichtung (14) nach Anspruch 1, wobei die Öffnung (38) als eine T-förmige Öffnung geformt ist und eine vergrößerte Öffnung (42) und eine schmale Öffnung (44) aufweist, die mit einer Seite der vergrößerten Öffnung (42) verbunden ist; an der Seitenwand (34) mindestens ein Anschlag (40) gebildet ist, der mit dem Einrastteil (30) in Berührung steht, um die Tiefe zu begrenzen, in die das Verbindungsglied (26) eingeschoben wird.

3. Die Übergangsvorrichtung (14) nach Anspruch 2, wobei sich der Einrastteil (48) vom federnden Arm (46) bis zur vergrößerten Öffnung (42) der Öffnung (38) erstreckt.

4. Die Übergangsvorrichtung (14) nach Anspruch 3, wobei der Einrastteil (48) mit einem vorstehenden Kontaktstück (62) an einer Stelle in Übereinstimmung mit dem Kontaktteil (56) gebildet ist; der Kontaktteil (56) einen Kontaktendteil (58) aufweist, der mit dem Kontaktstück (62) in Berührung ist, um den Einrastteil (30) mit dem Einschnappglied (28) zu positionieren.

5. Die Übergangsvorrichtung (14) nach Anspruch 4, wobei der Einrastteil (48) gegenüber dem Kontaktstück (62) mit einem gebogenen Teil (50) gebildet ist; der gebogene Teil (50) an einer Stelle in Übereinstimmung mit dem Einrastarm (52) angeordnet ist, wobei letzterer eine abgeschrägte Führungsfläche (60) aufweist, mit der der gebogene Teil (50) gleitbar in Berührung steht.

6. Die Übergangsvorrichtung (14) nach Anspruch 1, wobei der Knopf (64) mit zwei Flächen am federnden Arm (46) des Einschnappgliedes (28) befestigt ist.

## Revendications

1. Un dispositif de connexion (14) pour un bras de gestion des câbles (10) et un ensemble coulissant (12), comprenant :
un élément de raccordement (26) présentant une paire de parties courbées (32) et une paroi (34) connectée entre les parties courbées (32), un passage (36) défini par les parties courbées (32) et la paroi (34), la paroi (34) présentant une fenêtre (38) ;
un élément d'engagement (28) fixé sur la paroi (34) de l'élément de raccordement (26) et présentant un bras élastique (46) et une partie d'engagement (48), le bras élastique (46) se prolongeant vers la fenêtre (38) de l'élément de raccordement (26), et
une pièce d'insertion (30)
présentant deux bras d'insertion (52) et un corps (54) connecté entre les deux bras d'insertion (52), l'épaisseur de chaque bras d'insertion (52) étant calculée pour correspondre avec la largeur du passage (36) et les bras d'insertion (52) insérés dans le passage (36), l'un des bras d'insertion (52) présentant une partie de contact (56) située pour correspondre avec la partie d'engagement (48) ;
dans lequel, lorsque les bras d'insertion (52) de la pièce d'insertion (30) sont complètement insérés dans le passage (36), la partie d'engagement (48) de l'élément d'engagement (28) est située entre le corps (54) de la pièce d'insertion (30) et la partie de contact (56) du bras d'insertion (52) pour garder la pièce d'insertion (30) positionnée sur l'élément de raccordement (26), **caractérisé en ce que**
l'élément de raccordement est raccordé de façon fixe au bras de gestion des câbles (10), et
la pièce d'insertion (30) est fixée sur l'ensemble coulissant (12),
et dans lequel l'élément d'engagement (28) est fixé sur la paroi (34) de l'élément de raccordement (26) sur le même côté de la paroi (34) comme le côté où le passage (36) est défini et peut être poussé par l'une des directions de la fenêtre (38), et
le dispositif de connexion (14) utilise la fenêtre (38) pour accueillir des pièces de l'élément d'engagement (28) en saillie de façon à réduire de taille et occuper moins d'espace.

2. Le dispositif de connexion (14) selon la revendication 1, dans lequel la fenêtre (38) est une ouverture en forme de T et a un trou élargi (42) et un trou étroit (44) qui communique avec un côté du trou élargi (42), la paroi (34) a au moins une butée (40) qui est en contact avec la pièce d'insertion (30) pour limiter la profondeur d'insertion de la pièce d'insertion (30) dans l'élément de raccordement (26).

3. Le dispositif de connexion (14) selon la revendication 2, dans lequel la partie d'engagement (48) se prolonge à partir du bras élastique (46) et atteint le trou élargi (42) de la fenêtre (38).

4. Le dispositif de connexion (14) selon la revendication 3, dans lequel la partie d'engagement (48) a un élément de contact en saillie (62) qui est situé pour correspondre avec la partie de contact (56), la partie de contact (56) a une extrémité de contact (58) avec laquelle l'élément de contact (62) est en contact de sorte à ce que la pièce d'insertion (30) est positionnée par l'élément d'engagement (28).

5. Le dispositif de connexion (14) selon la revendication 4, dans lequel la partie d'engagement (48) a une partie courbée (50) située à l'opposé de l'élément de contact (62), la partie courbée (50) est située pour correspondre avec le bras d'insertion (52) qui a une surface de guidage inclinée (60) avec laquelle la partie courbée (50) est en contact de façon coulissante.

6. Le dispositif de connexion (14) selon la revendication 1, dans lequel un bouton (64) avec deux faces est connecté au bras élastique (46) de l'élément d'engagement (28).
